# EUROPEAN PATENT APPLICATION

(11) **EP 2 378 609 A1**
(43) Date of publication of application: **19.10.2011**
(21) Application number: 09834435.1
(22) Date of filing: 22.12.2009
(51) Int. Cl.: H01Q 1/40, H01P 11/00

(54) **FILM ANTENNA AND METHOD FOR MANUFACTURING THE SAME**

(30) Priority: 22.12.2008 JP 2008325645; 26.03.2009 JP 2009076236
(71) Applicant: Fujikura, Ltd., Tokyo 135-8512 (JP)
(72) Inventor: MATSUKAWA, Takashi, Sakura-shi Chiba 285-8550 (JP); SATOH, Yoshinori, Sakura-shi Chiba 285-8550 (JP); YOKOUCHI, Takashi, Sakura-shi Chiba 285-8550 (JP); YOSHIDA, Kensuke, Sakura-shi Chiba 285-8550 (JP); SHINOHARA, Tomoyuki, Sakura-shi Chiba 285-8550 (JP)
(74) Representative: Cabinet Plasseraud
(86) International application number: PCT/JP2009/007130
(87) International publication number: WO 2010/073627

(57) **Abstract**

A method of manufacturing a film antenna includes: a process of sticking a bonding surface of a bonding sheet to a surface of a metal thin film of a plastic film fitted with metal thin film; a process of forming the antenna circuit part by completely cutting the plastic film fitted with metal thin film in a thickness direction thereof from the bonding surface, and half-cutting the bonding sheet in a thickness direction thereof; a process of peeling away portions of the plastic film fitted with metal thin film around the antenna circuit part; a process of laminating a first flexible plastic film onto the plastic film fitted with metal thin film side; a process of peeling away the bonding sheet; and a process of laminating a second flexible plastic film onto the surface of the metal thin film.

## Description

### TECHNICAL FIELD

The present invention relates to a film antenna built into a small wireless electronic device, and a manufacturing method thereof.
Priority is claimed on Japanese Patent Application No. 2008-325645, filed December 22, 2008, and Japanese Patent Application No. 2009-076236, filed March 26, 2009, the contents of which are incorporated herein by reference.

### BACKGROUND ART

Recently, there is rapid progress in making small wireless electronic devices such as mobile telephones and personal digital assistants (PDA) smaller, lighter, and more multifunctional. Technological trends of these small wireless electronic devices include the production of mobile telephones with wireless communication functions such as Bluetooth (see Non-Patent Document 1) and wireless LAN. To realize these wireless communication functions, an antenna is built into the small wireless electronic device.

Plate antennas or flexible printed circuit (FPC) antennas are used in these wireless electronic devices. Since wireless electronic devices are recently being made smaller and thinner as mentioned above, there is a demand to make the built-in antennas smaller and thinner too. Moreover, wireless electronic devices increasingly contain a plurality of built-in antennas.

Wireless electronic devices are becoming more diverse, and there is a demand that the built-in antennas used in them have shapes that are suitable for the individual wireless electronic devices. For example, since the metal used in wireless electronic devices can alter the resonance frequency, a shape that achieves good gain for each device must be selected.

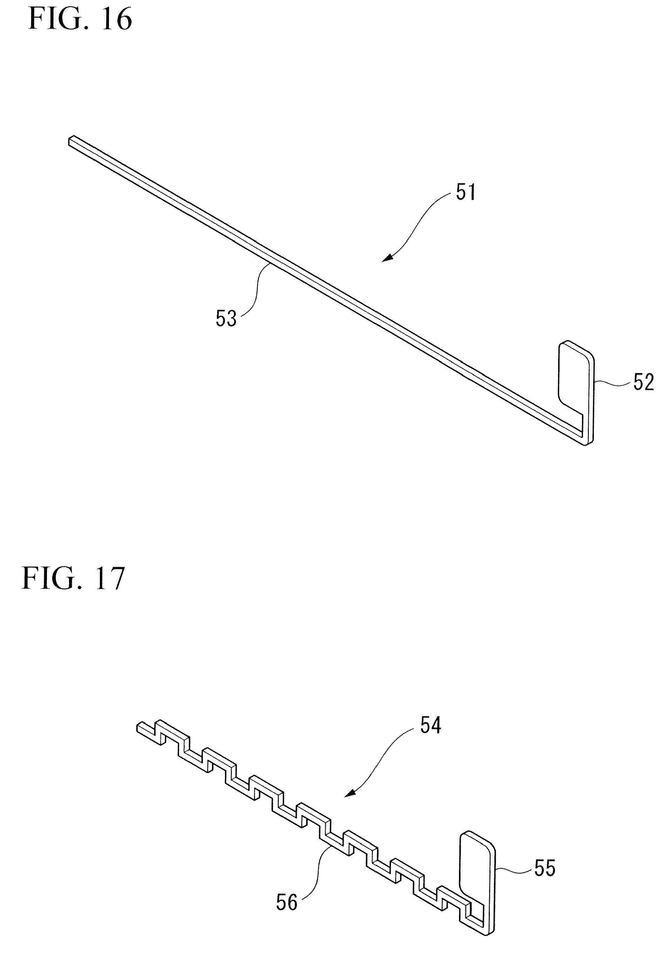

A plate antenna 51 shown in FIG. 16 is one example of a film antenna built into a small wireless electronic device of a related art. The plate antenna 51 includes an antenna element 53 (power supply element) and a power supply part 52.

To make the plate antenna smaller, a plate antenna 54 having a shape such as that shown in FIG. 17 is known in the art. By giving the antenna element 56 a zigzag shape, the antenna element 56 having a similar circuit length as the antenna element 53 of FIG. 16 can be realized in a narrower area. The plate antenna 54 can thus be made smaller. If a thin metal plate is used as the material for the plate antenna, it can be processed into a zigzag shape.

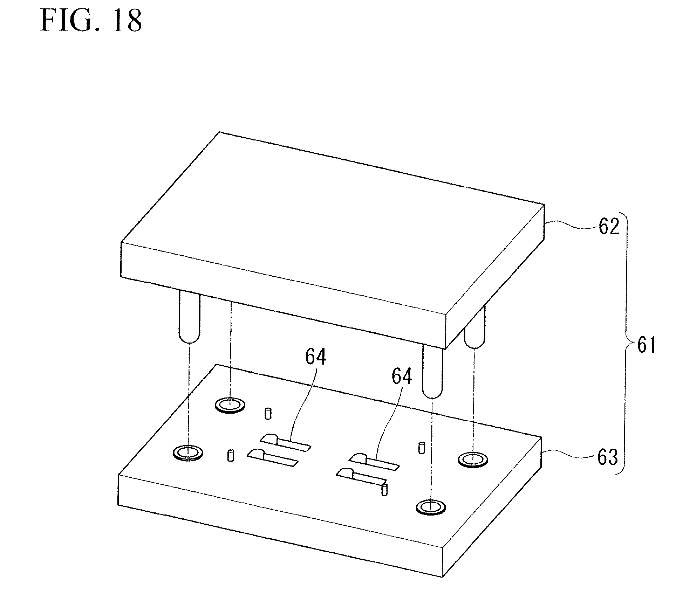

The circuits of the plate antennas 51 and 54 are formed by using a punching die 61 such as that shown in FIG. 18 to cut a metal plate having a thickness of 50 µm to 200 µm. A punching die 61 includes an upper die 62 and a lower die 63; the metal plate is sandwiched between the upper die 62 and the lower die 63, and punched with a punching part 64 to make the plate antennas 51 and 54.
This method has an advantage that the cost of processing the plate antennas 51 and 54 can be reduced.

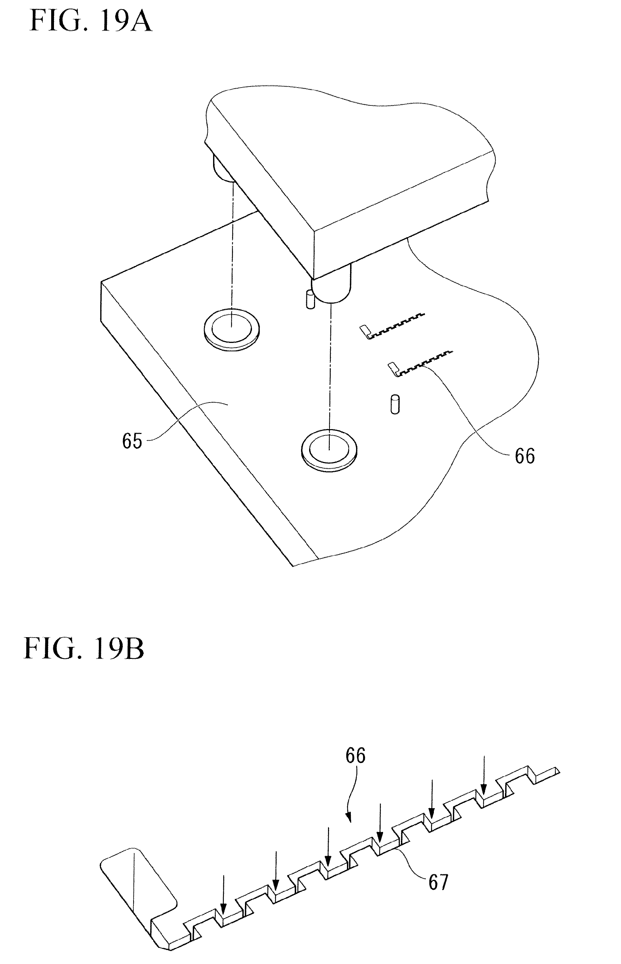

FIG. 19A is a perspective view of a related art punching die for a plate antenna, and FIG. 19B is a partially enlarged perspective view of the punching part in FIG. 19A. As shown in FIG. 19A, a small punching part 66 formed by the lower die 65 punches through the plate antenna. However, as shown in enlargement in FIG. 19B, when the small punching part 66 is pressed, a large force indicated by the arrows acts on the edging portion of zigzag-shaped parts 67 of the small punching part 66, resulting in a possibility that the die with break.

Other related art film antennas are described in, for example, Patent Documents 1 to 3.
Patent Document 1 discloses a reverse F-shaped plate antenna manufactured by bending the metal plate after cutting the metal plate. The metal plate antenna manufactured by this method can be manufactured comparatively inexpensively, and can be made small and with a low profile; hence it is generally used.

According to the antenna of Patent Document 2, there is disclosed a method that uses an FPC with an antenna pattern formed by etching. An etching process can form any given circuit shape. A copper-clad laminate (CCL) made by laminating a polyimide film onto copper foil is used as the FPC.

Patent Document 3 discloses a built-in antenna for mobile telephone. The antenna described in Patent Document 3 can be made smaller by forming the antenna element on the FPC in a spiral shape or a zigzag shape.

### PATENT LITERATURES

### [PATENT DOCUMENTS]

[Patent Document 1] Japanese Unexamined Patent Application, First Publication No. 2004-312166.
[Patent Document 2] Japanese Unexamined Patent Application, First Publication No. 2004-282250.
[Patent Document 3] Japanese Unexamined Patent Application, First Publication No. H5-7109.

### [NON-PATENT DOCUMENT]

[Non-patent Document 1] http://www.bluetooth.com/bluethooth/

### DISCLOSURE OF INVENTION

### [PROBLEMS TO BE SOLVED BY THE INVENTION]

In the plate antenna described above related art, when the plate is hard or thick, a punching die with high durability is required. Furthermore, when forming a zigzag-shaped antenna element from a hard plate material, a strong force acts on the lower die and leads to a danger of the die breaking or the antenna element breaking. It is therefore difficult to punch the plate into a complex shape.

A thin metal plate can also be used to form a complex shape. However, after punching, the antenna is liable to suffer to plastic deformation such as bending and snapping, making it difficult to handle after processing, and consequently difficult to maintain in a fixed shape. Also, when a film antenna suffers plastic deformation, the shape of the antenna changes; this greatly affects its receiving sensitivity.

Since the resonance frequency of a built-in antenna changes due to the effect of the metal used in the wireless electronic device, a shape that obtains good gain suitable for each individual device must be selected. A great number of experimental manufactures are needed to select the shape of the antenna element, and, since a die must be made for each shape, there are problems such as an extension of the lead time for experimental manufacture and an increase in the tool cost.

As disclosed in Patent Documents 2 and 3, to form a circuit by etching requires complex processes such as producing a resist for the pattern shape, and an etching process. Also, since copper foil polyimide film (CCL) is used in some antennas, there is a problem that even more material expense is needed.

In the etching process for forming the circuit, since tools such as an exposure film must be made for each antenna element, there are problems such as an extension of the lead time for experimental manufacture and an increase in the tool cost.

The present invention has been realized in view of these circumstances, and aims to provide a film antenna that can reduce costs and simplify the work processes, and to provide a method of manufacturing the antenna.

### [MEANS FOR SOLVING THE PROBLEMS]

In order to achieve the above objects, the invention uses the followings.
(1) A method of manufacturing a film antenna of an aspect of the invention includes sticking a bonding surface of a bonding sheet to a surface of a metal thin film of a plastic film fitted with metal thin film, forming the antenna circuit part by completely cutting the plastic film fitted with metal thin film in a thickness direction thereof from the bonding surface, and half-cutting the bonding sheet in a thickness direction thereof; peeling away portions of the plastic film fitted with metal thin film around the antenna circuit part, laminating a first flexible plastic film onto the plastic film fitted with metal thin film side, peeling away the bonding sheet, and laminating a second flexible plastic film onto the surface of the metal thin film.
(2) A plastic film fitted with bonding agent may be used as the first flexible plastic film.
(3) The method may further include forming gold plating on a power supply part of the antenna circuit part.
(4) The complete cutting and the half-cutting may be performed using a laser.
(5) The plastic film of the plastic film fitted with metal thin film may have an adhesive layer on a surface opposite to the first flexible plastic film.
(6) A film antenna of an aspect of the invention includes an antenna circuit part formed by cutting a plastic film fitted with metal thin film, and first and second flexible plastic film layers laminated on both surfaces of the antenna circuit part.
(7) A bonding agent layer may be formed on a rear surface of a surface of the first flexible plastic film layer that is laminated onto the antenna circuit part.
(8) The antenna circuit part may include a power supply part exposed through a hole formed in the second flexible plastic film layer; and a gold plating layer may be formed on the power supply part.
(9) The metal thin film of the plastic film fitted with metal thin film may be copper foil.
(10) The plastic film of the plastic film fitted with metal thin film may be a PET film.

### [EFFECTS]

According to the method of manufacturing a film antenna of the invention, since the antenna circuit part is formed only by cutting and without performing etching or printing, the cost can be reduced.
According to the method of manufacturing a film antenna of the invention, since the bonding sheet can prevent plastic deformation of the metal thin film, a circuit with a complex shape can be formed.
According to the method of manufacturing a film antenna of the invention, since a plastic film fitted with metal thin film is used in forming the antenna circuit part, the material cost can be reduced.

### BRIEF DESCRIPTION OF THE DRAWINGS

FIG. 1A is a view of a process of sticking a bonding sheet onto a plastic film fitted with metal thin film according to a first embodiment of the invention.
FIG. 1B is a view of a process of cutting a circuit layer using a pinnacle die according to the same embodiment.
FIG. 1C is a view of peeling a part other than an antenna circuit part and adhering of a first flexible plastic film according to the same embodiment.
FIG. 1D is a view of a process of exposing a surface of a metal thin film by peeling away a bonding sheet according to the same embodiment.
FIG. 1E is a view of a process of sticking a second flexible plastic film according to the same embodiment.
FIG. 2A is a perspective view of a plastic film fitted with metal thin film and a bonding sheet corresponding to FIG. 1A.
FIG. 2B is a perspective view of a plastic film fitted with metal thin film and a bonding sheet corresponding to FIG. 1B.
FIG. 2C is a perspective view of a plastic film fitted with metal thin film and a bonding sheet corresponding to FIG. 1C.
FIG. 2D is a perspective view of a plastic film fitted with metal thin film and a bonding sheet corresponding to FIG. 1D.
FIG. 2E is a perspective view of a plastic film fitted with metal thin film and a bonding sheet corresponding to FIG. 1E.
FIG. 3A is a perspective view for showing pinnacle blades for cutting six antenna element shapes formed on a top surface of a substrate of a pinnacle die according to the same embodiment.
FIG. 3B is an enlarged view of a pinnacle blade including a quadrangular frame-like cutting part and an elongated cutting part according to the same embodiment.
FIG. 4 is a view of a plastic film fitted with metal thin film after half cutting according to the same embodiment.
FIG. 5 is a perspective view of a bonding sheet after the plastic film fitted with metal thin film has been peeled from parts other than the antenna circuit part according to the same embodiment.
FIG. 6A is a perspective view of a film antenna after punching according to the same embodiment.
FIG. 6B is a transparent view of the film antenna according to FIG. 6A.
FIG. 7A is a perspective view of a film antenna according to the same embodiment.
FIG. 7B is a transparent view of the film antenna according to FIG. 7A.
FIG. 8A is a view of peeling of parts other than an antenna circuit part, and adhering of a first flexible plastic film, according to a second embodiment of the invention.
FIG. 8B is a view of a process of exposing a surface of a metal thin film by peeling away a bonding sheet according to the same embodiment.
FIG. 8C is a view of a process of sticking a flexible plastic film fitted with bonding agent according to the same embodiment.
FIG. 9A is a perspective view corresponding to FIG. 8A.
FIG. 9B is a perspective view corresponding to FIG. 8B.
FIG. 9C is a perspective view corresponding to FIG. 8C.
FIG. 10A is a perspective view of a film antenna after lamination according to the same embodiment.
FIG. 10B is a transparent view of the film antenna according to FIG. 10A.
FIG. 10C is an explanatory view of the formation of a gold plating of the film antenna according to FIG. 10A.
FIG. 10D is a view of the film antenna according to FIG. 10A after gold plating and punching.
FIG. 10E is a transparent view of the film antenna according to FIG. 10D.
FIG. 11A is a perspective view showing a pinnacle blade for cutting six antenna element shapes formed on a top surface of a substrate of a pinnacle die according to the same embodiment.
FIG. 11B is an enlarged view of a pinnacle blade including a cutting part and an elongated cutting part according to the same embodiment.
FIG. 12 is a perspective view of a laser marker with galvanometer mirror control according to a third embodiment of the invention.
FIG. 13 is a perspective view of a plastic film fitted with a metal thin film and a bonding sheet after cutting by laser according to the same embodiment.
FIG. 14A is a cross-sectional structural view of a film antenna according to a first embodiment of the invention.
FIG. 14B is a cross-sectional structural view of a film antenna according to a second embodiment of the invention.
FIG. 15A is a cross-sectional structural view of a related art film antenna.
FIG. 15B is a cross-sectional structural view of a related art film antenna.
FIG. 16 is a perspective view of a related art plate antenna.
FIG. 17 is a perspective view of a related art plate antenna with a zigzag-shaped antenna element.
FIG. 18 is a perspective view of a related art punching die for plate antenna.
FIG. 19A is a perspective view of a related art punching die for plate antenna.
FIG. 19B is a partially enlarged view of FIG. 19A.

### EMBODIMENTS FOR CARRYING OUT THE INVENTION

### [First Embodiment of Manufacturing Method]

Based on the drawings, a method of manufacturing a film antenna according to a first embodiment of the invention will be explained. However, this is not a limitation of the invention, which can be modified in various ways without departing from its main points.

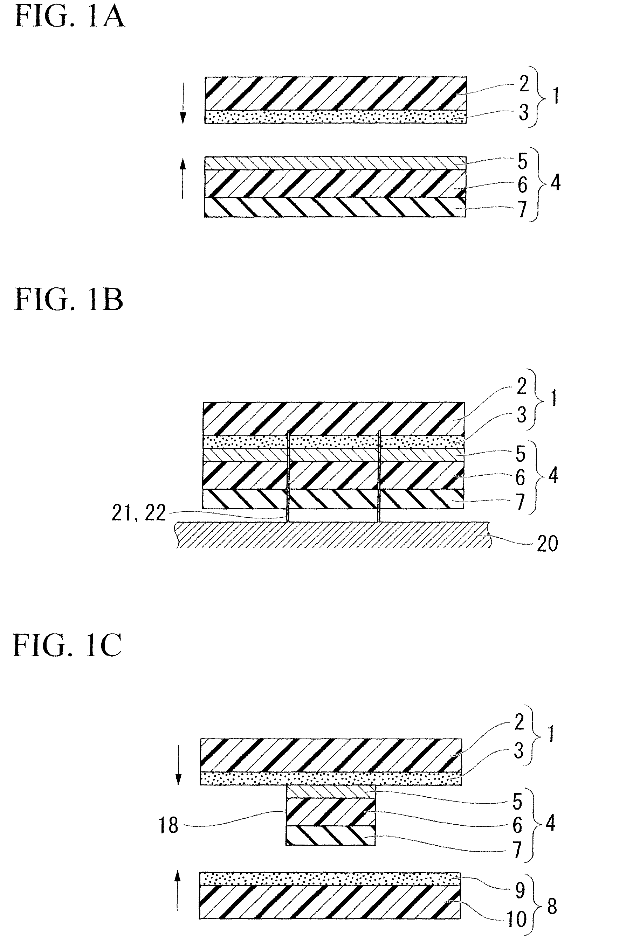

FIGS. 1A to 1E are cross-sectional views schematically illustrating a method of manufacturing a film antenna according to a first embodiment of the invention.
In FIG. 1A, a bonding sheet 1 includes a base material 2 made from plastic sheet and a bonding layer 3. While PET is preferably used as the plastic sheet of the base material 2, it is also acceptable to use polyethylene, polypropylene, or such like. The bonding sheet 1 need only be a lightly bonding sheet, with the bonding layer 3 preferably having a low bonding strength of approximately 0.1 N/cm to 1 N/cm.

The plastic film fitted with metal thin film 4 includes a metal thin film 5, a plastic film 6, and an adhesive layer 7. The plastic film fitted with metal thin film 4 is preferably formed from, for example, copper foil with a thickness of 6 µm to 18 µm, and a PET film with a thickness of 6 µm to 25 µm. While the adhesive layer 7 is preferably attached to the plastic film 6 side, the adhesive layer 7 may also not be attached. The adhesive layer 7 is preferably a thermoplastic adhesive agent. While aluminium foil-coated PET film is a suitable material for the plastic film fitted with metal thin film 4, it does not allow soldering and metal plating at the power supply part, and for that reason it is not actually used.

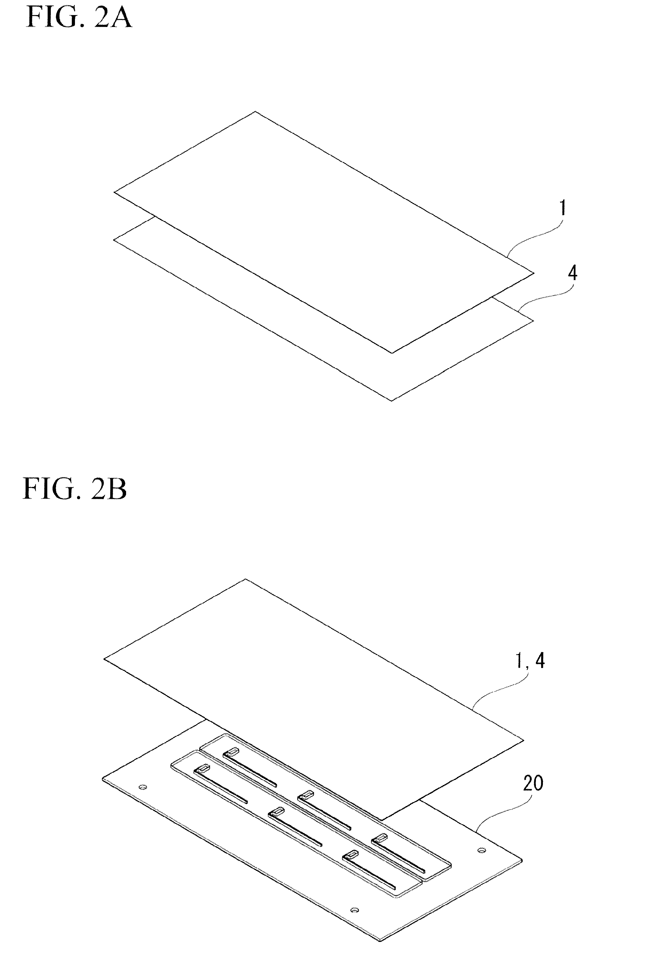

As shown in FIG. 1A, while manufacturing the film antenna according to this embodiment, the bonding layer 3 of the bonding sheet 1 firstly stick onto a top surface of the metal thin film 5 of the plastic film fitted with metal thin film 4. FIG. 2A is a perspective view of the plastic film fitted with metal thin film 4 and the bonding sheet 1 before sticking.

Subsequently, as shown in FIG. 1B, the plastic film fitted with metal thin film 4 is cut using a pinnacle die 20 for cutting circuit layer or the like, thereby forming a circuit layer (metal thin film 5) by the cutting. FIG. 2B is a perspective view thereof.

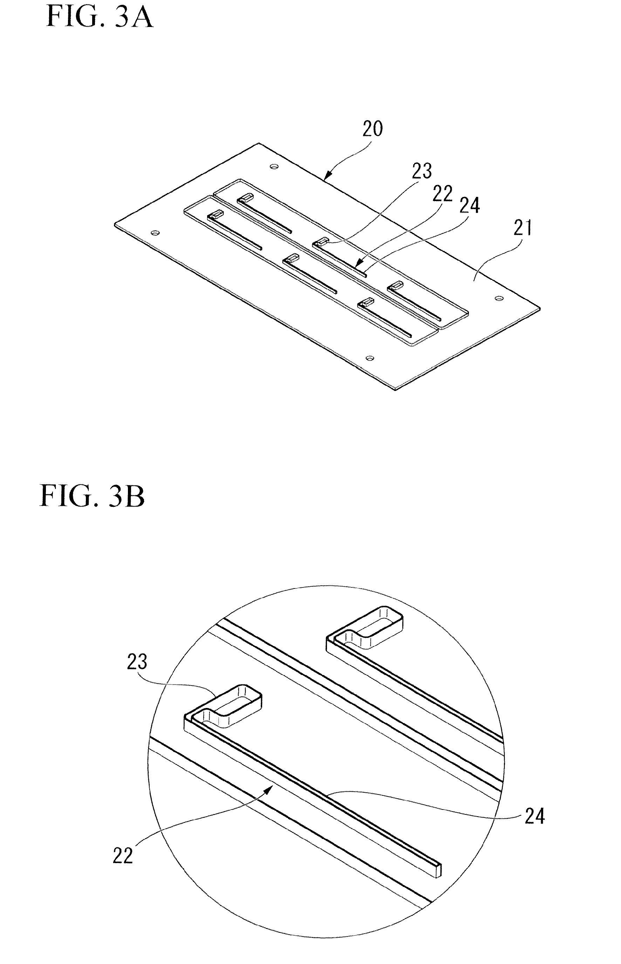

FIG. 3A is a perspective view of the pinnacle die 20. As shown in FIG. 3A, the pinnacle die 20 includes a substrate 21, and pinnacle blades 22 (cutting blades) which are formed on the top surface of the substrate 21. In the pinnacle die 20 of this embodiment, the pinnacle blades 22 are aligned in two columns and three rows such as to cut a total of six antenna elements. As shown in enlargement in FIG. 3B, each pinnacle blade 22 includes a quadrangular cutting part 23 for cutting the desired power supply part of the antenna, and an elongated cutting part 24 for cutting the desired element of the antenna. The pinnacle blades 22 enable the circuit to be finely shaped, and can cut to a circuit width of 0.5 mm, enabling the circuit to be formed in complex shape.
The cutting parts 23 and 24 have extending contours such that the antenna can be cut by low frame metal blades standing at a right angle to the top of the substrate 21.

As shown in FIG. 1B, regarding the cutting direction, cutting is performed from the plastic film fitted with metal thin film 4 side. That is, cutting is performed from the plastic film 6 side that is the opposite side to the metal thin film 5.
Assuming that only the plastic film fitted with metal thin film 4 is completely cut in its thickness direction to the shape of the intended antenna circuit part, while the bonding sheet 1 is half-cut, that is not completely cut in its thickness direction. The metal thin film 5 of the plastic film fitted with metal thin film 4 is cut by this complete cutting to form the intended antenna circuit part. In this embodiment, 'half-cutting of the bonding sheet 1 denotes a cut where, although the bonding layer 3 of the bonding sheet 1 is cut to a certain depth, the base material 2 is not cut. The shape of the plastic film fitted with metal thin film 4 after cutting is thus supported by the bonding sheet 1. However, this is not limitative of the invention; provided that the supporting force of the bonding sheet 1 is guaranteed, as shown in FIG. 1B, the base material 2 can also be cut to a certain depth. For example, the base material 2 can be cut to no more than half its thickness.

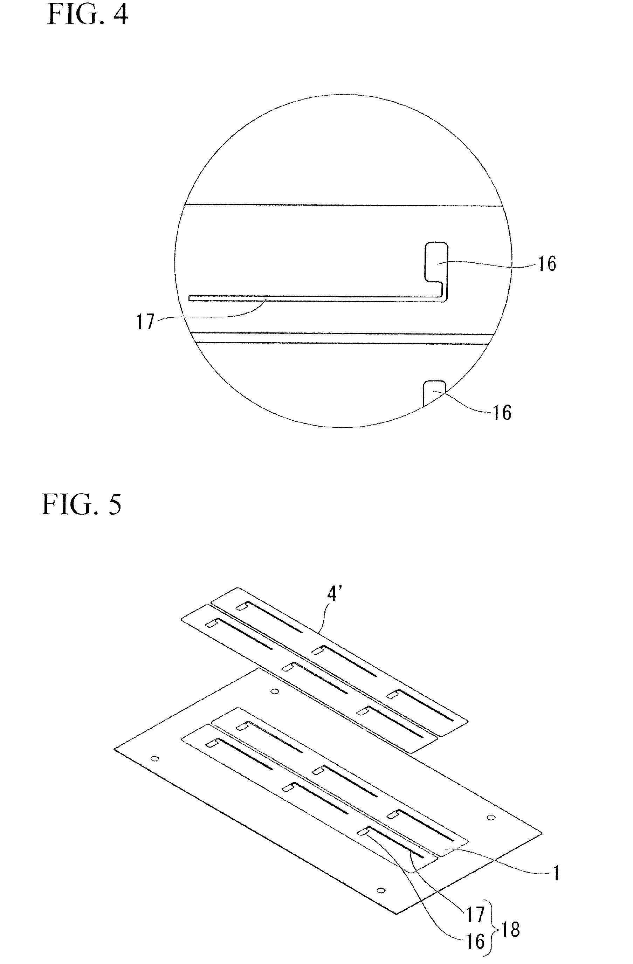

FIG. 4 illustrates the plastic film fitted with metal thin film 4 after half-cutting. Here, 'half-cutting' denotes a cut that collectively achieves the complete cutting of the plastic film fitted with metal thin film 4 and the half-cutting of the bonding sheet 1. This half-cutting does not completely sever the sheet containing the bonding sheet 1 and the plastic film fitted with metal thin film 4 which are stuck together; it completely cuts only the plastic film fitted with metal thin film 4.

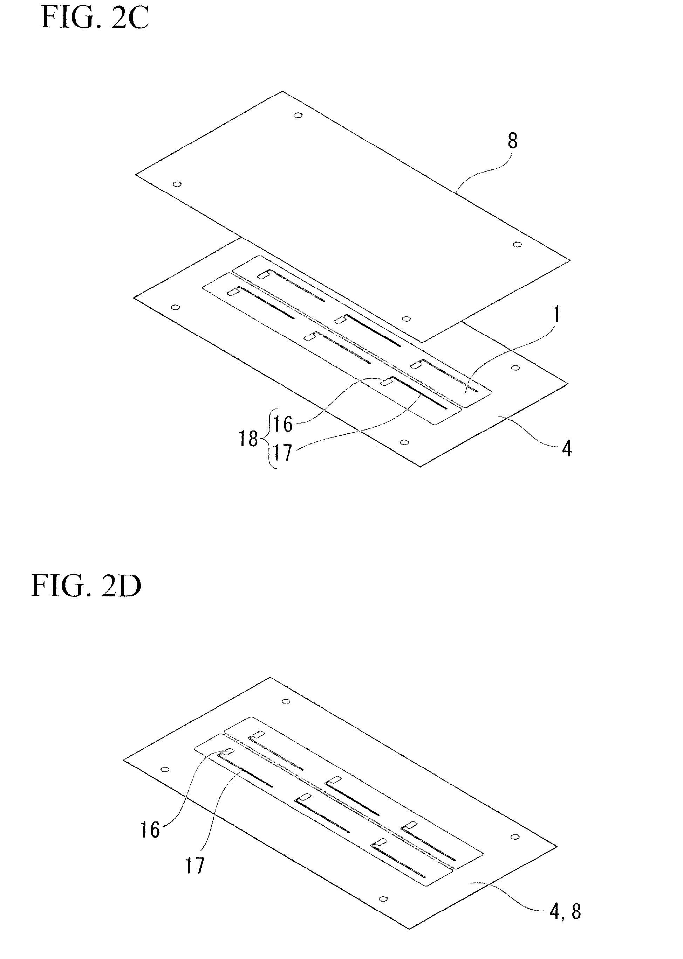

Subsequently, as shown in FIG. 1C, the unwanted portions of the plastic film fitted with metal thin film 4 stuck to the bonding sheet 1 other than the antenna circuit part are peeled away. That is, the portions around the antenna circuit part are peeled away. FIG. 2C is a perspective view thereof, and depicts the film 4 in a reversed state as the bonding sheet 1. As shown in FIG. 1C, when the unwanted portions are peeled away, an antenna circuit part 18 attached to the bonding sheet 1 is formed. The antenna circuit part 18 includes the metal thin film 5 and the plastic film 6, and when necessary may also contain an adhesive layer 7.

FIG. 5 is a perspective view of the sheet shape after the plastic film fitted with metal thin film 4' other than the antenna circuit part was peeled away. The antenna circuit part 18 includes a power supply part 16 and an antenna element 17, and is supported by the bonding sheet 1. This can suppress plastic deformation of the antenna circuit part 18, and enables a complex shape to be formed.

After the unwanted portions other than the antenna circuit part 18 have been peeled away, a first flexible plastic film 8 is bonded (affixed) on the antenna circuit part 18 side. The bonding method is preferably heat lamination using, for example, an iron.
When the antenna circuit part 18 and the first flexible plastic film 8 are heat laminated, the circuit can be secured at room temperature.

A flexible plastic film 10 using PET, polyimide, polypropylene, polyethylene naphthalate (PEN), or the like, can be used as the first flexible plastic film 8. When an adhesive layer 7 is not attached to the antenna circuit part 18, a flexible plastic film 10 fitted with an adhesive layer 9 can be used. The thickness of the first flexible plastic film 8 is preferably between 20 µm and 100 µm.

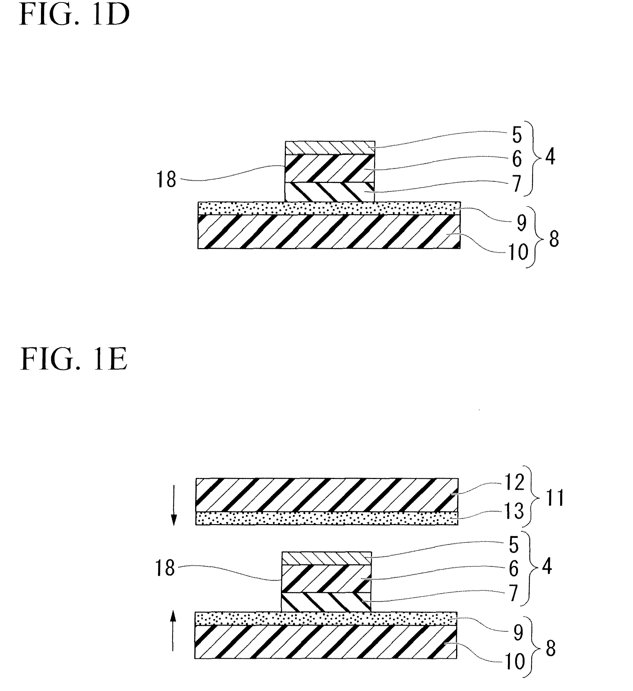

Subsequently, as shown in FIG. 1D, the bonding sheet 1 is peeled off to form the antenna circuit part 18 wherein the surface of the metal thin film 5 is exposed. FIG. 2D is a perspective view thereof. According to a related art etching methods and the like, a subsequent process can begin after the base material has sufficiently dried. It means the process have to wait until the base material has dried, as a result a long manufacturing time will be required. In contrast, according to this embodiment, the subsequent process can begin immediately after simply peeling away the bonding sheet 1, enabling the manufacturing time to be shortened.

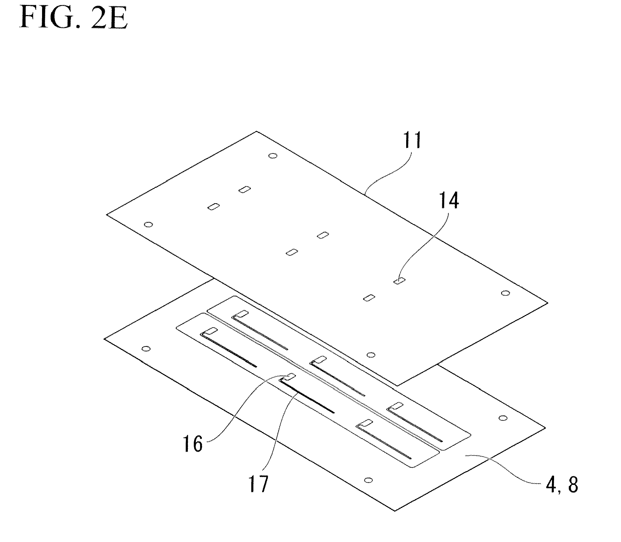

Subsequently, as shown in FIG. 1E, a second flexible plastic film 11 including a plastic film 12 and an adhesive layer 13 is bonded to the surface of the metal thin film 5. FIG. 2E is a perspective view thereof. While there is no particular restriction on the film used as the plastic film 12, it is preferable to use, for example, PET film fitted with a bonding layer, polyimide film fitted with an adhesive layer, PET film fitted with a heat seal material, or a polyimide film fitted with a heat seal material. The thickness of the second flexible plastic film 11 is preferably between 20 µm and 100 µm.

As shown in FIG. 2E, holes 14 corresponding to the power supply parts 16 are provided in the second flexible plastic film 11. In this embodiment, six holes 14 are formed. By laminating both sides of the antenna circuit part 18 with flexible plastic films in this manner, it is possible to manufacture a film antenna that does not plastic deform after processing.

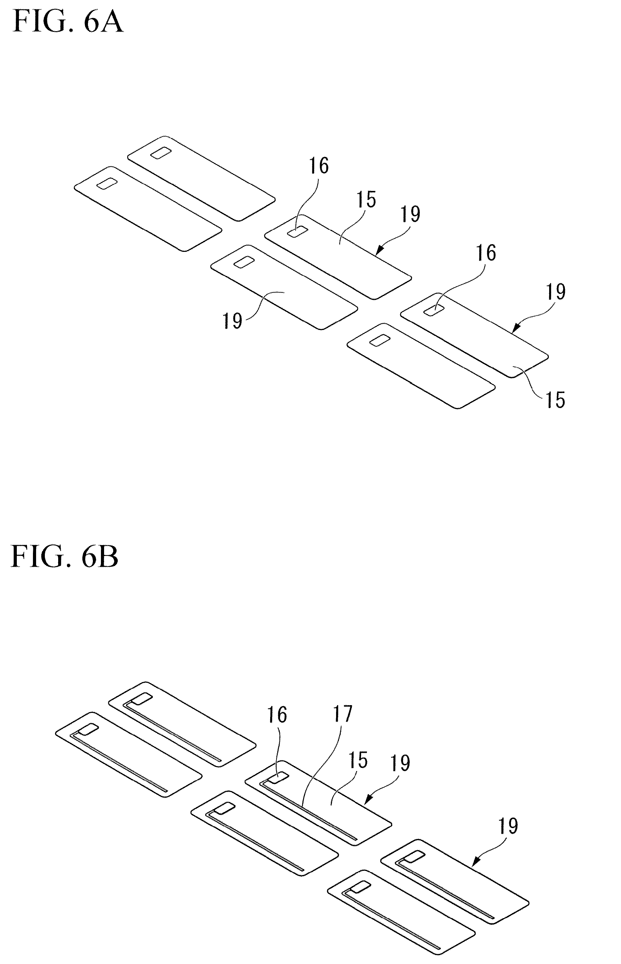

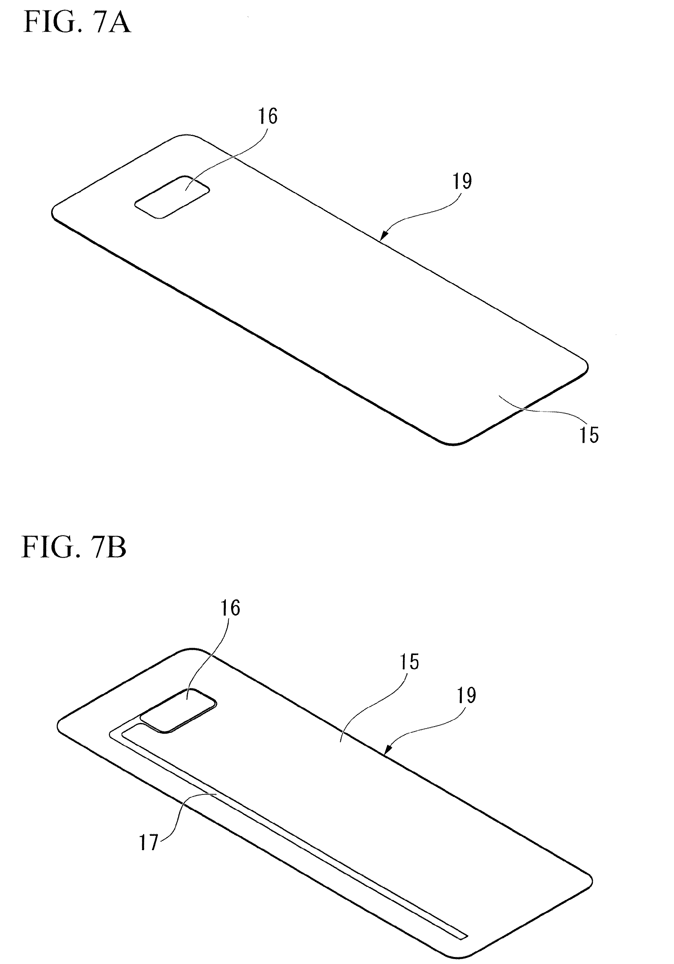

Subsequently, by punching the external shape of the product in the manner shown in FIGS. 6A and 6B, a film antenna 19 shown in FIGS. 7A and 7B can be manufactured. In this film antenna 19, the antenna circuit part 18 is covered by a cover part 15 including the first flexible plastic film 8 and the second flexible plastic film 11, and the power supply part 16 is exposed via the hole 14.

### [Second Embodiment of Manufacturing method]

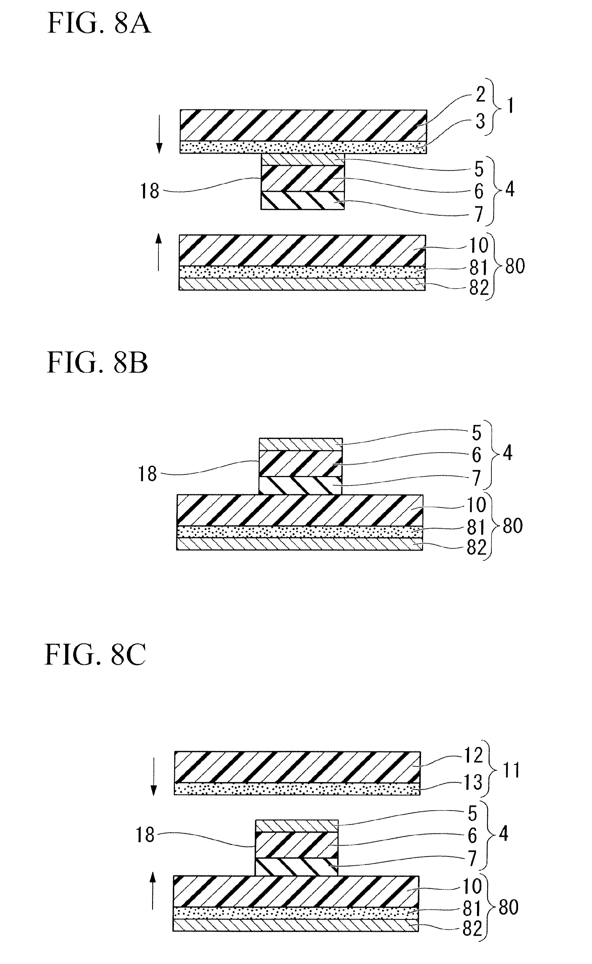

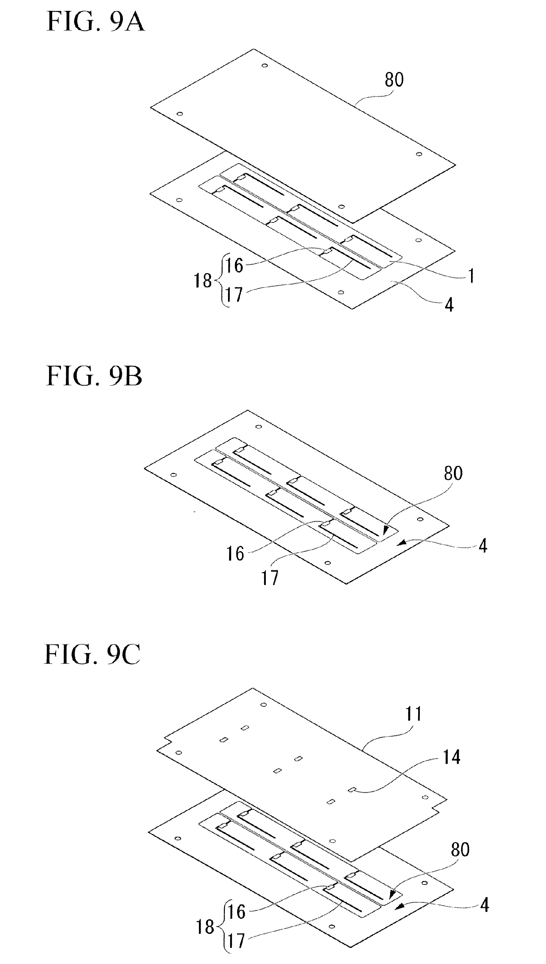

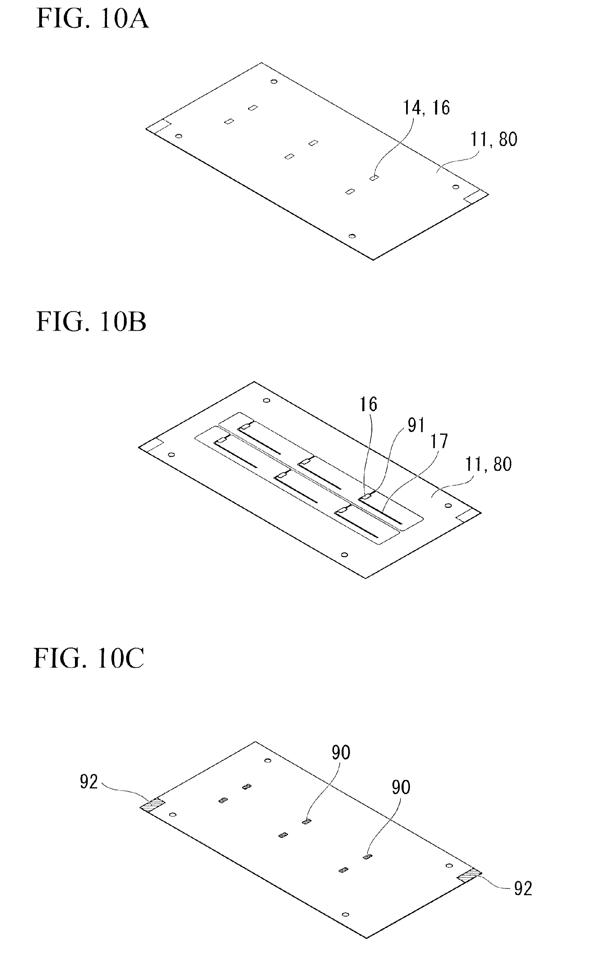

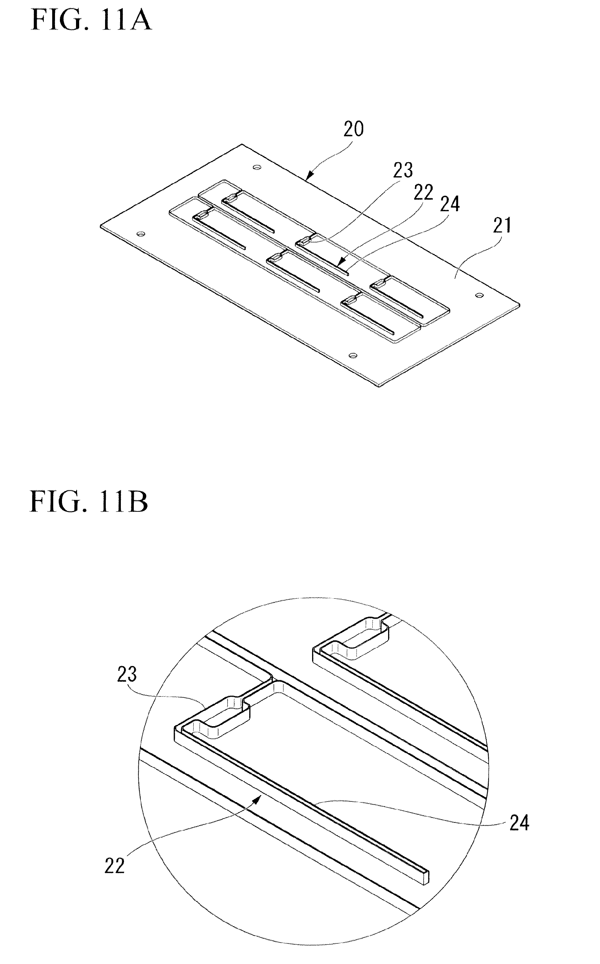

Based on FIG. 8A to FIG. 11B, a manufacturing method according to a second embodiment of the invention will be explained, concentrating on portions that differ from the first embodiment. FIGS. 8A to 8C are views of portions that differ from the first embodiment. FIGS. 9A to 9C are perspective views of a plastic film and a bonding sheet corresponding to FIGS. 8A to 8C. FIGS. 10A to 10E are perspective views of a film antenna which is manufactured according to this embodiment. FIGS. 11A and 11B are views of pinnacle blades according to this embodiment.

In the manufacturing method according to this embodiment, as shown in FIG. 1A, a bonding sheet 1 is bonded to the top surface of a metal thin film 5 of a plastic film fitted with metal thin film 4. The plastic film fitted with metal thin film 4 includes the metal thin film 5, a plastic film 6, and an adhesive layer 7. The adhesive layer 7 is preferably a thermoplastic adhesive agent.
In the same manner as in FIG. 1B, the plastic film fitted with metal thin film 4 is then completely cut, and the bonding sheet 1 is half cut by using a pinnacle die 20. As shown in FIGS. 11A and 11B, a pinnacle die 20 according to this embodiment includes six pinnacle blades 22 (cutting blades) for cutting antenna elements, formed on the top surface of a substrate 21, the same as the first embodiment. As shown in enlargement in FIG. 3B, each pinnacle blade 22 includes a quadrangular cutting part 23 for cutting the intended power supply part of the antenna, and an elongated cutting part 24 for cutting the intended element of the antenna. As in the first embodiment, the pinnacle blades 22 enable the circuit to be finely shaped, and can cut to a circuit width of 0.5 mm, enabling the circuit to be formed in complex shape. The pinnacle blades 22 can be set in accordance with the target antenna shape.
Unwanted parts other than the antenna circuit part are then peeled away to form the antenna circuit part 18 bonded to the bonding sheet 1.

Subsequently, as shown in FIG. 8A, a flexible plastic film fitted with bonding agent 80 is laminated onto the antenna circuit part 18 side. FIG. 9A is a perspective view thereof.
The flexible plastic film fitted with bonding agent 80 includes a flexible plastic film 10 as in the first embodiment, a bonding agent layer 81 formed on a rear surface thereof, and a peeling film 82. There are no particular limitations on the peeling film 82 other than that it is easy to peel off from the bonding agent layer 81. The flexible plastic film fitted with bonding agent 80 can be formed by coating the rear surface of the laminated surface of the flexible plastic film 10 with a bonding agent beforehand. Instead of the flexible plastic film 10, it is possible to use the first flexible plastic film 8 as in the first embodiment. That is, an adhesive layer 9 can be provided over the flexible plastic film 10 when necessary.

As shown in FIG. 8B, the bonding sheet 1 is then peeled away to form the antenna circuit part 18. FIG. 9B is a perspective view thereof.
Subsequently, as shown in FIG. 8C, the second flexible plastic film 11 having the holes 14 is adhered to the surface of the metal thin film 5. FIG. 9C is a perspective view thereof. As shown in FIG. 10A, two layers of flexible plastic film are thus laminated onto the top and bottom surfaces of the antenna circuit part 18, and only the power supply part 16 is exposed via the hole 4. As shown in FIGS. 10B and 10C, the power supply parts 16 are connected by copper foil at plating lead parts for plating power supply parts 91, and electrically connect to power supply parts for electrolytic plating 92 provided at the corners of the second flexible plastic film.

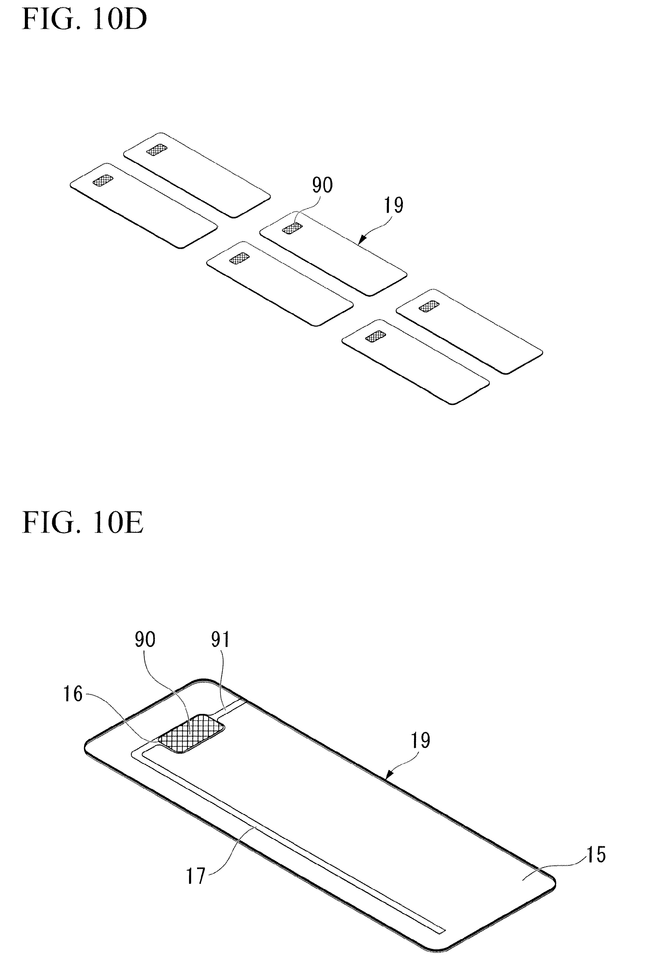

A voltage is applied to the power supply parts for electrolytic plating 92 that will become the outside connection points, whereby, as shown in FIGS. 10D and 10E, a gold plating layer 90 is formed on each exposed power supply part 16. The gold plating layer 90 includes a nickel plating layer of approximately 1 µm to 7 µm plated on a ground and a gold plating layer of approximately 0.5 µm to 3 µm plated on the nickel plating layer. The external shape is then cut to form the film antenna shown in FIG. 10E. The gold plating layer 90 prevents corrosion of the power supply parts 16 functioning as connection points, and reduces connection resistance with the outside.

The electrolytic gold plating is specifically performed as follows. After the second flexible plastic film 11 has been laminated, electrolytic gold plating is performed by connecting electrodes to the power supply parts for electrolytic plating 92 at the exposed corners. In this embodiment, in a state where a bonding agent is fitted to the rear surface of the flexible plastic film fitted with bonding agent 80, gold plating can be formed on the power supply parts 16 of the antenna circuit parts 18.

The film antenna of this embodiment includes a plastic film 6 having the same shape as the metal thin film 5 of the antenna circuit part 18.
In a related art etching method, a flexible plastic film fitted with bonding agent cannot be used in the etching solution used to remove the metal thin film and the resist at the time of forming the circuit. That is, in a related art etching method, gold plating cannot be performed when a bonding agent is fitted. Therefore, when it is necessary to bond a film antenna to the housing or the like of a mobile telephone, a double-faced adhesive agent must be bond to the rear surface of the antenna after the gold plating process.

In contrast, in the manufacturing method of this embodiment, gold plating of the power supply parts 16 is performed in a state where the bonding agent is fitted to the rear surface of the flexible plastic film fitted with bonding agent 80. Since this enables the film fitted with bonding agent to be used as it is, the only steps that need to be performed are peeling away the peeling film 82 and bonding the film antenna to the housing of the mobile telephone. Thus, according to this embodiment, there is no need to use a double-faced adhesive agent, enabling a reduction of the material cost.

In the first embodiment and in the second embodiment, either of the first flexible plastic film 8 and the flexible plastic film fitted with bonding agent 80 can be used.

### [Third Embodiment]

Subsequently, a method of manufacturing a film antenna according to a third embodiment of the invention will be explained based on the drawings. The explanation of this embodiment will concentrate on points of difference from the first and the second embodiments, and like portions will not be repetitiously explained.

In this embodiment, the circuit layer (metal thin film 5) is cut using a laser marker with galvanometer mirror control 70, instead of the pinnacle die 20 used in the first and the second embodiments. This point differs from the first embodiment and the second embodiment.

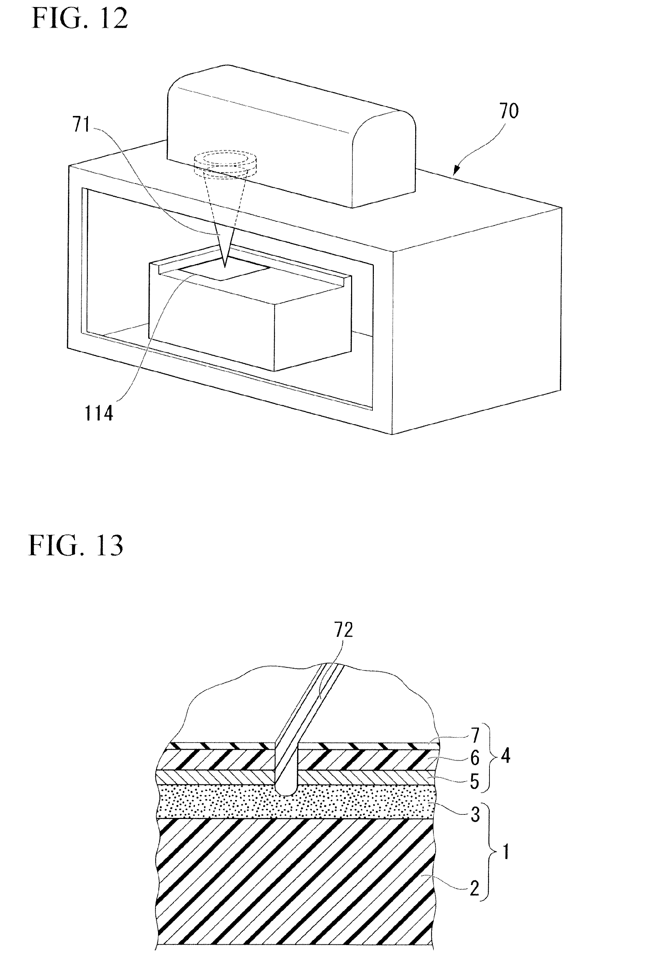

In this embodiment, the antenna circuit part 18 is formed by using a commonly-marketed laser marker with galvanometer mirror control 70, such as the one shown in FIG. 12, to cut the plastic film fitted with metal thin film 4.
A circuit layer (metal thin film 5) can be cut by marking the shape of the antenna circuit part by the laser marker with galvanometer mirror control 70. As an irradiation direction of the laser 71, the laser 71 irradiates from the plastic film fitted with metal thin film 4 side, performing a complete cut only of the plastic film fitted with metal thin film 4, and a half-cut of the bonding sheet 1 such that it is not completely cut in its thickness direction. The shape of the thin plastic film fitted with metal thin film 4 after cutting is thus supported by the bonding sheet 1.

FIG. 13 is a cross-section of the bonding sheet 1 and the plastic film fitted with metal thin film 4 after cutting by the laser 71. A laser cutting part 72 completely cuts the plastic film fitted with metal thin film 4, and half-cuts the bonding layer 3 of the bonding sheet 1. While in FIG. 13 the laser cutting part 72 does not reach as far as the base material 2 made from a plastic sheet, it can acceptably reach the base material 2. That is, provided that the whole bonding sheet 1 can support the shape of the plastic film fitted with metal thin film 4 after cutting without completely cut the base material 2 made from a plastic sheet, the laser cutting part 72 can cut as far as the base material 2. By using a laser to cut the plastic film fitted with metal thin film 4, it is possible to manufacture a small antenna with a complex shape.

The laser used is preferably a YAG laser with a wavelength of 1064 nm. Since the wavelength of a YAG laser has high metal absorption, it can cut the metal thin film 5. On the other hand, the wavelength of a YAG laser has low resin absorption. Cutting is made possible by using a thin PET film of roughly 1 µm to 25 µm as the plastic film 6 of the plastic film fitted with metal thin film 4.

If a PET film of 50 µm to 75 µm is used as the base material 2 made from plastic sheet of the bonding sheet 1, it is possible to cut only the plastic film fitted with metal thin film 4 without completely cutting the bonding sheet 1.
While the laser used here is preferably a YAG laser, an SHG laser, a semiconductor laser, or a CO₂ laser can also be used.

According to this embodiment, by using a laser marker with galvanometer mirror control to cut the plastic film fitted with metal thin film, a small antenna with a complex shape can be manufactured. Also, according to this embodiment, the shape of the antenna element can be freely modified at low cost and in a short time. Therefore, the lead time in experimental manufacture can be shortened and the tool cost can be reduced.

### [Embodiment of the Device]

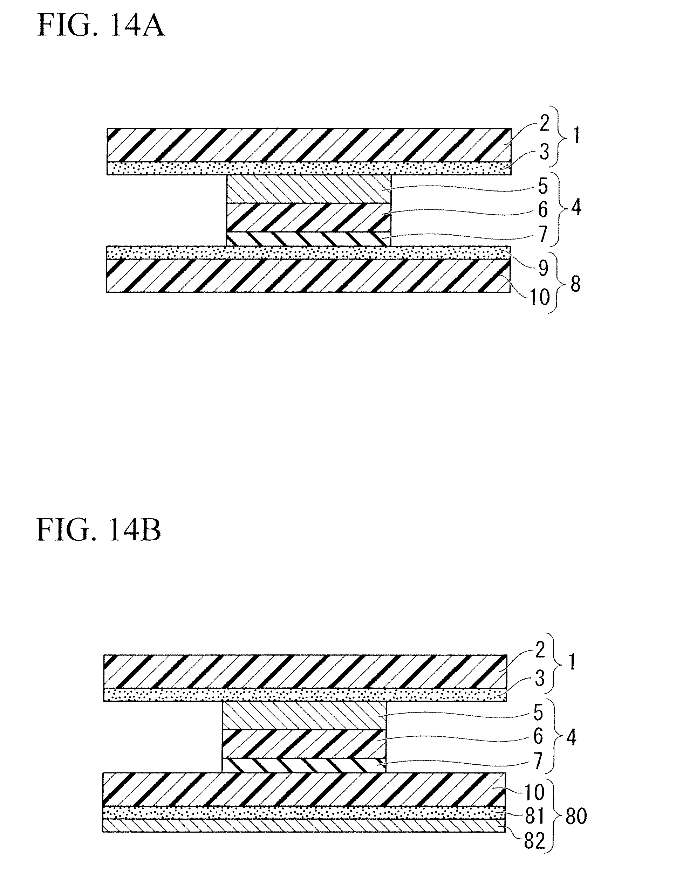

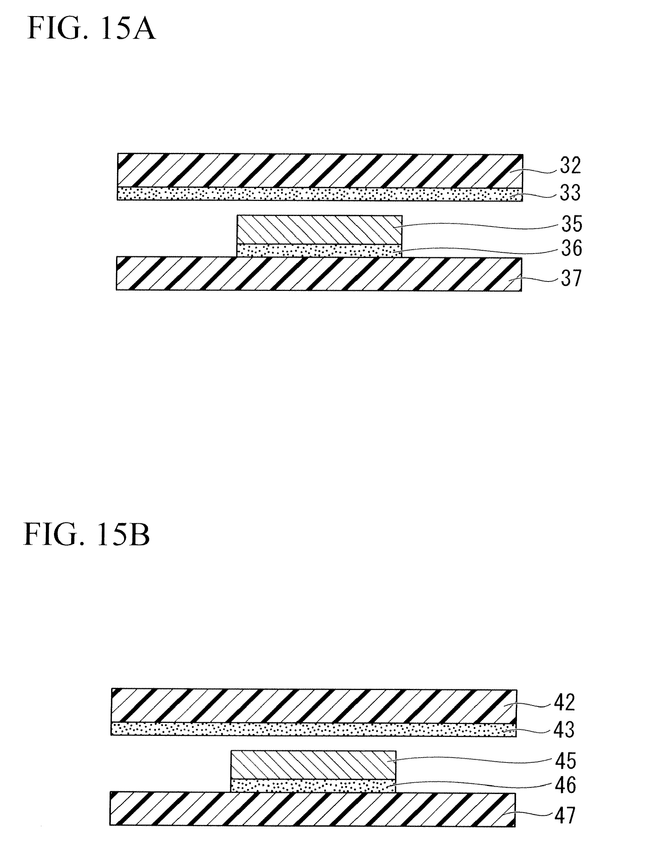

FIGS. 14A and 14B are structural cross-sectional views of plastic film antennas fitted with metal thin film that were manufactured by cutting processes according to the first and the second embodiments. FIG. 15A is a structural cross-sectional view of an FPC antenna manufactured by an etching process of the related art. FIG. 15B is a structural cross-sectional view of a PET film fitted with metal thin film manufactured by an etching process of the related art.

The structure of the FPC antenna manufactured by the related art of FIG. 15A includes polyimide layers 32 and 37 laminated onto a metal thin film layer 35. An adhesive layer 33 bonds the polyimide layer 32 to the metal thin film layer 35, and an adhesive layer 36 bonds the polyimide layer 37 to the metal thin film layer 35.

The structure of the PET film antenna fitted with metal thin film manufactured by the related art etching process of FIG. 15B includes PET layers 42 and 47 laminated onto a metal thin film layer 45. An adhesive (or bonding) layer 43 adheres the polyimide layer 42, and an adhesive layer 46 adheres the polyimide layer 47.

In comparison with these antennas of related art, as shown in FIG. 14A, the film antenna according to the first embodiment of the invention includes the plastic film layer 6 which is the same size and shape as the metal thin film layer 5. This point is its most conspicuous structural difference with respect to the related art antennas. An antenna with the above structure can be manufactured by using the cutting process of the invention to cut a PET film antenna fitted with metal thin film. The plastic film layer 6 has an adhesive layer on the surface opposite the first flexible plastic film 8. While FIG. 14A illustrates the adhesive layers 7 and 9 simultaneously, a single adhesive layer is also acceptable.

In comparison with the film antenna manufactured by the etching process shown in FIGS. 15A and 15B, the film antenna shown in FIG. 14A which includes the antenna circuit part formed by the cutting process of the invention has a lower product cost.

Furthermore, in comparison with the film antenna using polyimide fitted with metal thin film of FIG. 15A, the film antenna of the invention using a PET film fitted with metal thin film can keep the material cost low.

Moreover, the structure of the film antenna of the invention uses a metal thin film, and both surfaces of the antenna circuit part are sandwiched between plastic films. Therefore, in comparison with a related art plate antenna using a thick metal plate to avoid plastic deformation, the invention can form a complex antenna circuit part, and can manufacture a small film antenna with no plastic deformation after processing.
By using a thermoplastic adhesive agent as the adhesive agent for connecting the plastic film fitted with metal thin film to the first flexible plastic film, the antenna circuit part can be reliably secured to the first flexible plastic film at room temperature. If a bonding agent is used instead of an adhesive agent, an external force makes the circuit move, leading to deterioration in the characteristics of the antenna.

As shown in FIG. 14B, the film antenna according to the second embodiment of the invention has the structural characteristics of the antenna of FIG. 14A, and is also provided with the bonding agent layer 81 on the rear surface of the flexible plastic film (installation surface). In the first embodiment, when the flexible plastic film fitted with bonding agent 80 is used instead of the first flexible plastic film 8, the film antenna can include the bonding agent layer 81 as in the antenna shown in FIG. 14B.

When sticking a related art antenna to the housing or the like of a mobile telephone, a double-faced adhesive agent must be bonded to the installation surface of the antenna. Whereas in the invention, since the bonding agent layer 81 is already formed in the manufacturing stage, the film antenna can be bonded directly to the housing or the like. Therefore, the film antenna of the invention does not require sticking of a double-faced adhesive agent, and can be used conveniently.

### [INDUSTRIAL APPLICABILITY]

The film antenna of the invention can be applied in electronic devices provided with a wireless function, such as mobile telephones, televisions, wireless headphones, PDA, digital cameras, and videos. The manufacturing method of the invention can also be used in manufacturing a card antenna such as an RFID.

### [REFERENCE NUMERALS]

- 1: Bonding sheet
- 2: Base material made from plastic sheet
- 3: Bonding layer
- 4: Plastic film fitted with metal thin film
- 5: Metal thin film
- 6: Plastic film
- 7: Adhesive layer
- 8: First flexible plastic film
- 9: Adhesive layer
- 10: Flexible plastic film
- 11: Second flexible plastic film
- 12: Flexible plastic film
- 13: Adhesive layer
- 14: Hole for power supply part
- 15: Cover part
- 16: Power supply part
- 17: Antenna element
- 18: Antenna circuit part
- 19: Film antenna
- 20: Pinnacle die
- 22: Pinnacle blade (cutting blade)
- 23, 24: Cutting parts
- 32, 37: Polyimide layers
- 33, 36: Adhesive layers
- 35: Metal thin film layer
- 42, 47: PET film layer
- 43: Adhesive or bonding layer
- 45: Metal thin film layer
- 46: Adhesive layer
- 51: Plate antenna
- 52: Power supply part
- 53: Antenna element
- 54: Plate antenna
- 55: Power supply part
- 56: Antenna element
- 61: Punching die
- 62: Upper die
- 63: Lower die
- 64: Punching part
- 65: Lower die
- 66: Punching part
- 70: Laser marker with galvanometer mirror control
- 80: Flexible plastic film fitted with bonding agent
- 81: Bonding agent layer
- 82: Peeling film
- 90: Gold plating layer
- 91: Plating lead part for plating power supply part
- 92: Power supply part for electrolytic plating

## Claims

1. A method of manufacturing a film antenna, comprising:
sticking a bonding surface of a bonding sheet to a surface of a metal thin film of a plastic film fitted with metal thin film;
forming the antenna circuit part by completely cutting the plastic film fitted with metal thin film in a thickness direction thereof from the bonding surface, and half-cutting the bonding sheet in a thickness direction thereof;
peeling away portions of the plastic film fitted with metal thin film around the antenna circuit part;
laminating a first flexible plastic film onto the plastic film fitted with metal thin film side;
peeling away the bonding sheet; and
laminating a second flexible plastic film onto the surface of the metal thin film.

2. The method of manufacturing a film antenna according to claim 1, wherein a plastic film fitted with bonding agent is used as the first flexible plastic film.

3. The method of manufacturing a film antenna according to claim 1 or 2, further comprising forming a gold plating on a power supply part of the antenna circuit part.

4. The method of manufacturing a film antenna according to claim 1 or 2,
wherein the complete cutting and the half-cutting are performed using a laser.

5. The method of manufacturing a film antenna according to one of claims 1 to 4, wherein the plastic film of the plastic film fitted with metal thin film has an adhesive layer on a surface opposite to the first flexible plastic film.

6. A film antenna comprising:
an antenna circuit part formed by cutting a plastic film fitted with metal thin film; and
first and second flexible plastic film layers laminated on both surfaces of the antenna circuit part.

7. The film antenna according to claim 6, wherein a bonding agent layer is formed on a rear surface of a surface of the first flexible plastic film layer that is laminated onto the antenna circuit part.

8. The film antenna according to claim 6 or 7, wherein the antenna circuit part comprises a power supply part exposed through a hole formed in the second flexible plastic film layer; and
a gold plating layer is formed on the power supply part.

9. The film antenna according to one of claims 6 to 8, wherein the metal thin film of the plastic film fitted with metal thin film is copper foil.

10. The film antenna according to one of claims 6 to 9, wherein the plastic film of the plastic film fitted with metal thin film is a PET film.
